# EUROPÄISCHE PATENTSCHRIFT

(11) **EP 0 427 143 B1**
(45) Veröffentlichungstag und Bekanntmachung des Hinweises auf die Patenterteilung: **15.02.1995**
(21) Anmeldenummer: 90121048.4
(22) Anmeldetag: 02.11.1990
(51) Int. Cl.: H01L 25/07

(54) **Leistungshalbleitermodul**
Semiconductor power module
Module à semi-conducteur de puissance

(30) Priorität: 07.11.1989 DE 3937045
(43) Veröffentlichungstag der Anmeldung: 15.05.1991
(73) Patentinhaber: IXYS Semiconductor GmbH, D-68623 Lampertheim (DE)
(72) Erfinder: Bayerer, Reinhold,Dr., W-6101 Reichelsheim (DE); Schneider, Thomas, W-6711 Beindersheim (DE)
(74) Vertreter: Rupprecht, Klaus, Dipl.-Ing.

(56) Entgegenhaltungen:
- EP-A- 0 166 968
- EP-A- 0 277 546
- ETZ ELEKTROTECHNISCHES ZEITSCHRIFT, Band 110, Nr. 10, Mai 1989, Seiten 472-477,Berlin, DE; R. BAYERER: "Anwendung, Ansteuerung und Kurzschlussschutz von IGBT"

## Beschreibung

Die Erfindung bezieht sich auf ein Leistungshalbleitermodul mit mindestens einer Halbbrücke. Leistungshalbleitermodule mit Halbbrücken werden beispielsweise zum Aufbau von Drehstrom-Umrichtern für elektrische Antriebe verwendet. Umrichter enthalten einen Gleichrichterteil, einen Gleichstromzwischenkreis mit einem Kondensator und einem Wechselrichterteil. Der Leistungsteil des Wechselrichters kann mit Halbbrückenmodulen aufgebaut werden, welche Gegenstand der Erfindung sind. Solche Leistungshalbleitermodule enthalten entweder nur eine Halbbrücke, so daß für einen Drehstromwechselrichter drei Module benötigt werden, oder sie enthalten z.B. bereits drei miteinander verschaltete Halbbrücken.

Für solche Umrichteranwendungen wird die Verwendung schnell und verlustarm schaltender Halbleiterschalter bevorzugt. Geeignet sind daher besonders Halbbrückenmodule, welche schnell schaltende Insulated-Gate-Bipolar-Transistoren (IGBT) als Halbleiterschalter und ultraschnelle Freilaufdioden enthalten. Derartige Halbbrückenmodule und ihre Anwendung sind in etz Bd. 110 (1989), Heft 10, Seiten 472 bis 477 (Druckschrift 1) beschrieben. Dort wird auch dargelegt (vgl. Bild 3 bis 5 und zugehörigen Text), daß Halbbrückenmodule und ein damit aufgebauter Leistungsteil eines Umrichters niederinduktiv ausgelegt werden müssen, um die Entstehung von Spannungsspitzen zu vermeiden. Das bedeutet, daß Streuinduktivitäten zwischen dem Kondensator im Gleichstromzwischenkreis und den Anschlußklemmen des Halbbrückenmoduls sowie zwischen diesen Klemmen und den Halbleiterschaltern im Modul klein sein müssen. Streuinduktivitäten ab etwa 100 nH führen bereits zu Spannungsspitzen, welche die Halbleiterschalter wesentlich belasten oder sogar deren Grenzdaten überschreiten.

In der EP-A1- 0277 546 (Druckschrift 2) ist eine Halbleiteranordnung beschrieben, deren zwei, den Laststrom führenden Hauptanschlußleiter dicht beieinander angeordnet und induktivitätsarm aufgebaut sind.

In der Druckschrift 1 und auch in etz Bd. 108, Heft 19, Seiten 922 bis 924 (Druckschrift 3) ist aufgezeigt, daß besonders hohe Spannungsspitzen beim Abschalten eines im Lastkreis aufgetretenen Kurzschlusses entstehen und daß eine bekannte Anordnung von Stützkondensatoren nicht ausreicht, um bei schnellem Schalten unzulässige Spannungsspitzen zu vermeiden.

Ein weiteres Problem besteht bei Halbbrückenmodulen darin, daß die Rückkopplungen vom Hauptstromkreis auf den Steueranschluß (Gate) eines Halbleiterschalters das Schaltverhalten beeinflussen. In der Druckschrift 3 ist auf Seite 924, linke Spalte dargelegt, daß auch diese Rückkopplungen mit kleinerer Streuinduktivität abnehmen. Rückkopplungen entstehen hauptsächlich durch parasitäre Induktivitäten und Transformatoren in den Halbleiterschalter-Anordnungen. Schon geringe Asymmetrien in den parasitären Induktivitäten und Transformatoren führen zu einer ungleichen Stromaufteilung in den Chips und zu unterschiedlichen Belastungen.

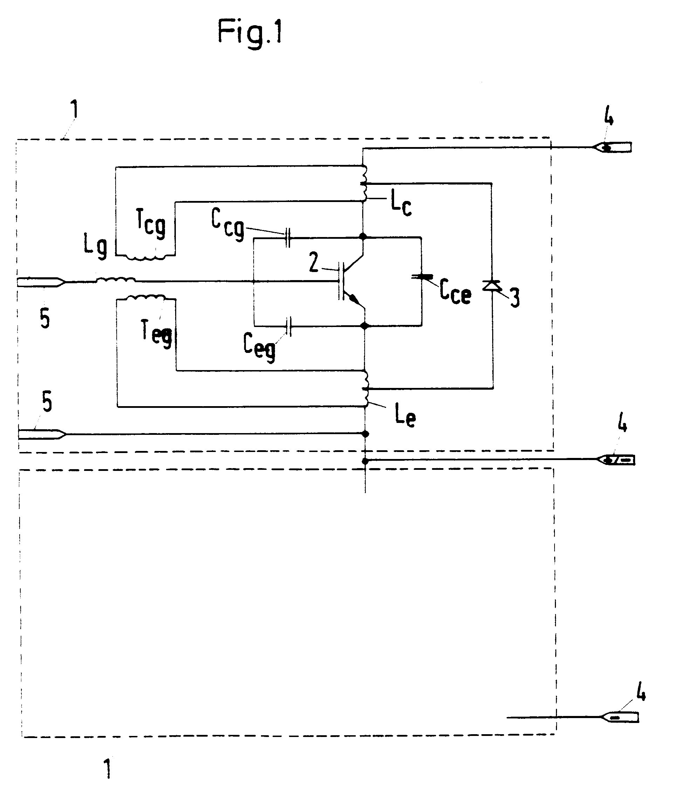

Die hier angesprochenen Induktivitäten und Transformatoren sind in einem in Figur 1 dargestellten Ersatzschaltbild für eine Halbbrücke mit konventionellem Aufbau angegeben. Die Halbbrückenschaltung besteht aus zwei Halbleiterschaltern 1, welche jeweils mindestens einen Leistungstransistor 2, hier einen IGBT, enthalten und eine parallelgeschaltete Freilaufdiode 3. In der Figur 1 ist nur das Ersatzschaltbild für einen der beiden identisch aufgebauten Halbleiterschalter 1 gezeigt. Die Bauelemente-Anschlüsse bilden in Verbindung mit Leitungen, die zu Hauptanschlüssen 4 und Steueranschlüssen 5 führen, eine Reihe von Kapazitäten und Induktivitäten bzw. Transformatoren, welche Rückwirkungen des Laststromes auf den Steuerkreis verursachen. Solche Kapazitäten sind die dargestellte Kollektor-Gate-Kapazität C_{Cg}, die Kollektor-Emitter-Kapazität C_{Ce} und die Emitter-Gate-Kapazität C_{eg}. Wirksame Induktivitäten sind eine Kollektor-Induktivität L_{C}, Emitter-Induktivität Lₑ und Gate-Induktivität L_{c}. Die Gate-Anschlußleitung bildet zusammen mit der Kollektor-Anschlußleitung einen Transformator T_{cg} und zusammen mit der Emitteranschlußleitung einen Transformaotr T_{eg}.

In Proceedings 4th international Macroelectronic conference, 1988, München, Seiten 134 bis 144 (Druckschrift 4) ist ein Halbbrücken-Leistungshalbleitermodul beschrieben, dessen Halbleiterschalter aus parallelgeschalteten IGBTs bestehen. Auf Seite 136 ist dort dargelegt, daß die Anzahal parallel schaltbarer Leistungstransistoren wegen des Einflusses der parasitäten Induktivitäten begrenzt ist. Ein symmetrischer und niederinduktiver Modulaufbau wird als Vorgabe für den Modulentwurf genannt, um Rückkopplungsprobleme zu verringern. Als Lösung wird ein quasi koaxialer Aufbau mit einer sternförmigen Anordnung der Leistungstransistoren vorgeschlagen. Außerdem wird eine Trennung von Hauptemitter und Hilfsemitter und ein Anschluß des Hauptemitters mittels einer Vielzahl von Drahtverbindungen empfohlen. Die Figuren 3, 7 und 8 in der Druckschrift 4 zeigen entsprechend ausgeführte Modul-Konstruktionen.

Die vorgeschlagene koaxiale Geometrie führt zwar wegen der symmetrischen Anordnung der Steueranschlüsse zu einer Reduzierung von Rückkopplungen, die Streuinduktivität ist jedoch nahezu so hoch wie bei sonstigen Standardmodulen. Die koaxiale Geometrie läßt sich nämlich nicht durchgehend von den Halbleiterschaltern bis zu den Modul-Hauptanschlüssen realisieren. Außerdem kann die koaxiale Geometrie bei einer größeren Anzahl von parallel zu schaltenden Leistungstransistoren nicht einmal für die Parallelschaltung selbst exakt eingehalten werden.

Ausgehend von dem der Druckschrift 1 entnehmbaren Stand der Technik liegt der Erfindung die Aufgabe zugrunde, ein Halbbrückenmodul anzugeben, das geringe Streuinduktivitäten in der gesamten Anordnung aufweist und das für die Parallelschaltung einer größeren Anzahl von Leistungstransistoren geeignet ist.

Diese Aufgabe wird durch ein Leistungshalbleitermodul gelöst, mit
- mindestens einer Halbbrücke, wobei eine Halbbrücke erste und zweite in Reihe geschaltete Halbleiterschalter enthält, die jeweils aus mehreren parallelgeschalteten ersten und zweiten Leistungstransistoren bestehen,
- einem keramischen Substrat als Modulboden, auf dem in einer Metallschichtebene liegende, isolierte Verbindungsleiterbahnen vorhanden sind, die aus einer Pluspolfläche, eine Mittelanzapfungsfläche, und mindestens zwei inselförmigen und elektrisch isoliert innerhalb der Mittelanzapfungsfläche liegenden Minuspolflächen bestehen; wobei:
- die ersten Transistoren auf der Pluspolfläche und die zweiten Transistoren auf der Mittelanzapfungsfläche aufgelötet sind;
- die ersten Transistoren durch Drähte mit der Mittelanzapfungsfläche und die zweiten Transistoren durch Drähte mit den Minuspolflächen elektrisch verbunden sind;
- drei Hauptanschlußleitungen je Halbbrücke zur Stromführung zwischen drei Modul-Hauptanschlüssen und den Halbleiterschaltern vorhanden sind, wobei jede Hauptanschlußleitung mit der jeweils zugehörigen Verbindungsleiterbahn elektrisch leitend verbunden ist, und die drei Hauptanschlußleitungen aus breiten Bändern mit geringem Abstand zueinander bestehen, um eine induktivitätsarme Anordnung zu erreichen; und
- die Pluspolanschlußleitung im Bereich der Anschlußstelle mit der Pluspolfläche mit Ausschnitten versehen ist, und wenigstens ein Teil der Drähte zur elektrischen Verbindung zwischen den ersten Transistoren und der Mittelanzapfungsfläche durch die Ausschnitte der Pluspolanschlußleitung geführt ist.

Die Aufgabe wird außerdem gelöst durch ein Leistungshalbleitermodul mit
- mindestens einer Halbbrücke, wobei eine Halbbrücke erste und zweite in Reihe geschaltete Halbleiterschalter enthält, die aus mehreren parallelgeschalteten ersten bzw. zweiten Leistungstransistoren bestehen;
- einem keramischen Substrat als Modulboden, auf dem isolierte Verbindungsleiterbahnen vorhanden sind, die aus einer Pluspolfläche, einer Mittelanzapfungsfläche, und einer Minuspolfläche in einer übereinandergeschichteten Folge der Pluspolfläche, einer zweiten Isolierschicht, der Mittelanzapfungsfläche, einer dritten Isolierschicht und der Minuspolfäche, bestehen, wobei:
- die ersten Transistoren auf der Pluspolfläche, und die zweiten Transistoren auf der Mittelanzapfungsfläche aufgelötet sind;
- die ersten Transistoren durch Drähte mit der Mittelanzapfungsfläche und die zweiten Transistoren durch Drähte mit der Minuspolfläche elektrisch verbunden sind;
- drei Hauptanschlußleitungen je Halbbrücke für die Pluspol-, die Minuspol- und die Mittelanzapfungsfläche zur Stromführung zwischen drei Modul-Hauptanschlüssen und den Halbleiterschaltern vorhanden sind, wobei jede Hauptanschlußleitung mit der jeweils zugehörigen Verbindungsleiterbahn elektrisch leitend verbunden ist, und die drei Hauptanschlußleitungen aus breiten Bändern mit geringem Abstand zueinander bestehen, um eine induktivitätsarme Anordnung zu erreichen; und
- die Geometrie der Verbindungsleitungen sich in die Hauptanschlußleitungen fortsetzt.

Die erfindungsgemäßen Lösungen haben unter anderem den Vorteil, daß ein standardisiertes Gehäuse verwendet werden kann und innerhalb des Gehäuses ein quasi magnetfeldfreier Raum entsteht, in welchem Elektronikbauteile zur Ansteuerung von Leistungstransistoren untergebracht werden können und störungsfrei arbeiten. Der induktivitätsarme Aufbau ermöglicht es einhundert und mehr Leistungstransistoren parallel zu schalten. Die damit verbundene Möglichkeit, die Last auf viele Transistoren gleichmäßig aufzuteilen, ist sehr vorteilhaft hinsichtlich der Verteilung und Abfuhr der Verlustwärme.

Auf in Halbbrücken- oder Wechselrichterschaltungen übliche Freilaufdioden können in gleicher Weise wie die Transistoren an die Verbindungsleiterbahnen angeschlossen werden.

Nach einer weiteren vorteilhaften Ausgestaltung kann je Halbbrückenschaltung ein Stützkondensator in Form eines Chip-Kondensators in eine Verbindungsbandleitung auf dem Substrat am optimalen Ort eingesetzt werden. Der Stützkondensator kann damit vollständig in die Bandleitungsgeometrie integriert werden. Für einen Anwender eines Moduls mit integriertem Stützkondensator bedeutet es eine wesentliche Vereinfachung, daß er sich um die Dimensionierung und richtige Anordnung von Stützkondensatoren nicht zu kümmern braucht.

Die Ausführung von Last- oder Steuerleitungen in einem Leistungshalbleitermodul in der Form von Bandleitungen wurde an sich bereits in der DE 35 38 933 vorgeschlagen. Dort handelte es sich allerdings um ein völlig anderes Modul, nämlich um ein Modul mit einzelnen Schaltfunktionen. Würde man gemäß dem dortigen Vorschlag oder gemäß der Druckschrift 2 jeweils die zwei Hauptanschlüsse eines Halbleiterschalters mit einer Bandleitung zu Modulanschlüssen führen und außen verdrahten, so ergäben sich noch nicht die Vorteile der erfindungsgemäßen Anordnung. Es wurde erkannt, daß mit der erfindungsgemäßen Anordnung der drei Hauptanschlußleitungen Plus-Leitung, Minus-Leitung und Mittelanzapfung als Bandleitung, in welcher jeweils zwischen zwei Leitungen ein Strom fließt, eine streuinduktivitätsarme Gesamtanordnung auch dann möglich ist, wenn man nur ein sogenanntes Single-Layer-Substrat verwendet. Die Anschlußbandleitung muß lediglich breit und mit geringem Bandabstand ausgeführt werden, angepaßt an die Anordnung der parallelgeschalteten Leistungstransistoren. Die Bandleitungsgeometrie-Anforderungen lassen sich dann auch über entsprechend plazierte Bonddrähte bis hin zu den Chips einhalten.

Weitere Vorteile und Einzelheiten der Erfindung ergeben sich aus in der Zeichnung dargestellten und nachstehend beschriebenen Ausführungsbeispielen.

Es zeigen:
- Fig. 1: Ersatzschaltbild einer Halbbrückenschaltung mit Transistoren,
- Fig. 2: eine erste Ausführungsvariante eines Halbbrückenmoduls,
- Fig. 3: eine zweite Ausführung eines Halbbrückenmoduls,
- Fig. 4: einen Bandleitungsanschluß an einem Modul und
- Fig. 5: ein Modul mit integriertem Stützkondensator.

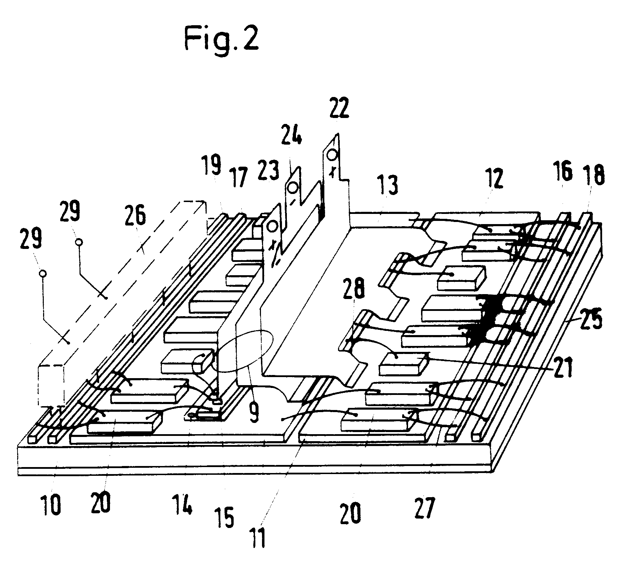

Fig. 2 zeigt eine erste Modulvariante, welche von einem Single-Layer-Substrat ausgeht. In Fig. 2 ist ein bestücktes Substrat ohne Kunststoffhaube dargestellt.

Auf einem Keramiksubstrat 10, welches die Bodenplatte des Moduls bildet, ist eine Metallschicht 11 mit Hilfe eines Direktverbindungsverfahrens aufgebracht und anschließend durch Ätzen strukturiert zu mehreren Metallflächen, nämlich zu einer Pluspolfläche 12, einer Mittelabgriffsfläche 13 und zu mehreren, z.B. drei Minuspolflächen 15 und zu ersten und zweiten Hilfsemitterstreifen 16, 17 sowie ersten und zweiten Gate-Streifen 18, 19. Die isolierten inselförmigen Minuspolflächen 15, von denen in der Fig. 2 nur eine der Flächen und nur teilweise zu sehen ist, sind durch Ätzen von Ausnehmungen 14 in die Mittelabgriffsfläche 13 hergestellt.

Auf den Mittelabgriffsflächen 13 und Pluspolflächen 12 sind Leistungstransistor-Chips 20, z.B. IGBT-Chips oder MOS-FETs, und Diodenchips 21 aufgelötet.

Auf den Pluspol-, Minuspol- und Mittelabgriffsflächen 12, 15, 13 sind außerdem breite Hauptanschlußleitungen 22, 23, 24 aufgelötet, welche einen solchen Abstand zueinander haben, daß sie eine erste Anschlußbandleitung 9 bilden. Die Dimensionierung der Bandleitung kann nach bekannten Gleichungen erfolgen. Die Induktivität L einer solchen Bandleitung ist proportional zum Abstand d der dünnen Metallbänder und deren Länge 1, dividiert durch die Breite a der Bänder. Für eine Bandleitung mit d = 1 mm, a = 30 mm und 1 = 50 mm ergibt sich beispielsweise eine Induktivität L von nur 2 nH. Die Abstände zwischen den großflächigen Anschlußleitungen 22, 23, 24 können beispielsweise durch Abstandsstücke aus einem Isolierstoff, z.B. Kunststoff, gesichert werden. Die Abstandsstücke sind in Fig. 2 nicht dargestellt.

Elektrische Verbindungen zwischen den Chips 20, 21 und den metallischen Flächen 12, 13, 15 bis 19 sind durch Drähte 27 nach einem Draht-Bondverfahren hergestellt. Um kurze Drahtverbindungen zwischen den Chips 20, 21 und der Mittelabgriffsfläche 13 herstellten zu können, enthält die Pluspolanschlußleitung 22 im Bereich ihrer Anschlußstelle an die Pluspolfläche 12 Ausschnitte 28. Obwohl durch Anschlüsse im Bereich der Ausschnitte 28 oder auch durch Anschlüsse an die inselförmigen Minuspolflächen 15 eine ideale Bandleitungsgeometrie nicht eingehalten werden kann, werden durch diese Störstellen nur geringe Streuinduktivitäten verursacht.

In Fig. 2 ist weiterhin mit gestrichelten Linien ein Ansteuerbaustein 26 angedeutet, welcher in dem quasi magnetfeldfreien Raum des Moduls angeordnet werden kann. Ein zweiter solcher Baustein 26 (in Fig. 2 nicht gezeichnet) kann auf der rechten Seite der Fig. 2 über den ersten Gatestreifen 16 und Emitterstreifen 18 angeordnet werden. Den Ansteuerbausteinen 26 werden Steuersignale über Steueranschlüsse 29 zugeführt. Alle Abstände der Anschlußleitungen von den Ansteuerbausteinen 26 über die Gatestreifen 18, 19, Hilfsemitterstreifen 16, 17 und die Bonddrähte 27 zu den Transistor- oder Dioden-Chips 20, 21 sind unter dem Gesichtspunkt gewählt, eine Bandleitungsgeometrie wenigstens annähernd zu erreichen. Damit werden Rückwirkungen vom Lastkreis auf den Steuerkreis minimiert.

Schließlich ist in Fig. 2 noch eine Bodenmetallisierung 25 auf der Unterseite des Keramiksubstrats 1 dargestellt, welche ebenso wie die Metallschicht 11 auf der Oberseite des Substrats 1 aus einer Kupferfolie besteht, welche mit einem Direktverbindungsverfahren aufgebracht ist. Die Bodenmetallisierung 25 wirkt einer möglichen Wolbung des Substrats aufgrund von Ausdehnungsunterschieden und der Bruchgefahr entgegen.

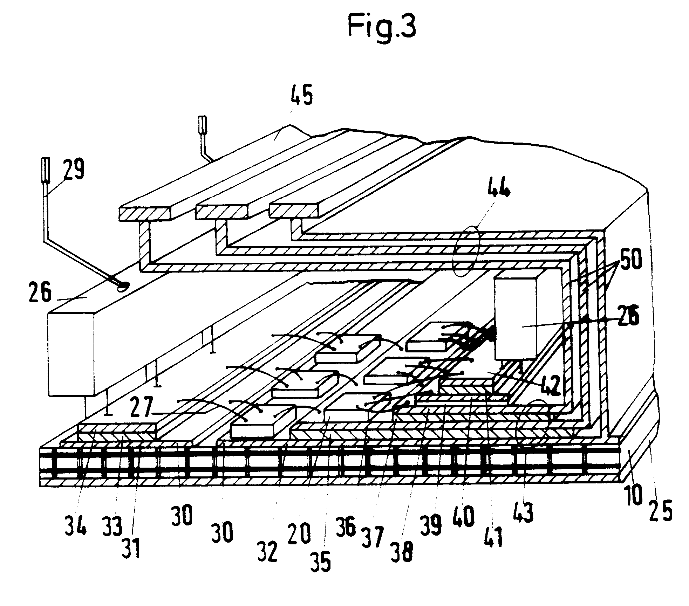

In Fig. 3 sind zur leichteren Orientierung alle Teile, welche mit denjenigen der Fig. 2 übereinstimmen mit gleichen Bezugszeichen versehen. Auch bei Fig. 3 ist das Modulgehäuse weggelassen, um den inneren Aufbau sichtbar zu machen. Alle Metallschichten auf dem Substrat bestehen aus einer Kupferfolie, welche nach einem Direktverbindungsverfahren mit als Isolierschicht zwischengefügten Keramikplättchen verbunden sind.

Als Bodenplatte wird ein Keramiksubstrat 10 mit einer Bodenmetallisierung 25 verwendet. Auf der Oberseite des Substrats 10 ist eine erste Metallschicht 30 aufgebracht, welche in eine erste Hilfsemitterfläche 31 und eine Pluspolfläche 32 unterteilt ist.

Über der ersten Hilfsemitterfläche 31 ist eine erste keramische Isolierschicht 33 und darüber eine erste Gatefläche 34 angeordnet. Die erste Gatefläche 34 und die erste Isolierschicht 33 sind kleiner als die erste Hilfsemitterschicht 31 ausgeführt, so daß Anschlußflächen für Bonddrähte 27 zur Verfugung stehen.

Über der Pluspolfläche 32 ist eine zweite Isolierschicht 35 und darüber eine Mittelanzapfungsfläche 36 angeordnet. Die Mittelanzapfungsfläche 36 mit Isolierschicht 35 ist kleiner als die Pluspolfläche 32, so daß auf der freien Pluspolfläche 32 Transistorchips 20 und Diodenchips (nicht dargestellt) aufgelötet werden können.

Auf der Mittelanzapfungsfläche 36 ist ebenfalls eine Reihe von Transistorchips 20 aufgelötet und daneben eine dritte Isolierschicht 37 mit einer darauf angeordneten Minuspolschicht 38.

Auf der Minuspolschicht 38 ist eine vierte Isolierschicht 39, eine zweite Hilfsemitterfläche 40, eine fünfte Isolierschicht 41 und eine zweite Gatefläche 42 angeordnet, wobei diese Flächen in ihrer Größen abgestuft sind, so daß Anschlußflächen für Bonddrähte 27 zur Verfügung stehen. Mit Hilfe der Bonddrähte 27 und der metallisierten Flächen 31, 32, 34, 36, 38 und 40 sind sowohl die elektrischen Verbindungen für den Lastkreis der Halbbrückenschaltung als auch für die Ansteuerung hergestellt.

Über den Gate- und Hilfsemitterflächen 34, 31 bzw. 42, 40 sind jeweils mit einem geeigneten Abstand Ansteuerbausteine 26 angeordnet und elektrisch mit diesen Flächen verbunden. Die Ansteuerbausteine 26 sind mit nach außen führenden Steueranschlüssen 29 versehen.

Die Pluspol-, Mittelanzapfungs- und Minuspolflächen 32, 36, 38, welche eine Verbindungsbandleitung 43 auf dem Substrat bilden, sind über eine zweite Anschlußbandleitung 44 zu flächigen Hauptanschlüssen 45 geführt. Die zweite Anschlußbandleitung 44 ist aus drei breiten metallischen Bändern 50 aufgebaut, welche im erforderlichen Abstand zueinander mit Hilfe nicht gezeigter Isolierstücke angeordnet sind.

Die flächigen Hauptanschlüsse 45 ermöglichen eine Fortsetzung der idealen Bandleitungsgeometrie auch an der Anschlußstelle und in Verbindungsschienen für eine elektrische Verbindung von Halbbrückenmodulen.

Als Bandleitung ausgeführte modulexterne Verbindungsschienen lassen sich vorteilhaft auch zur Verbindung von Modulen nach der ersten Ausführung gemäß Fig. 2 verwenden. Obwohl das Modul gemäß Fig. 2 etwa punktförmige Hauptanschlüsse aufweist und damit die Anschlußstelle eine Störstelle in der Bandleitungsanordnung darstellt, läßt sich damit ein wesentlicher Effekt hinsichtlich Induktivitätsreduzierung und Magnetfeldeinschluß erzielen.

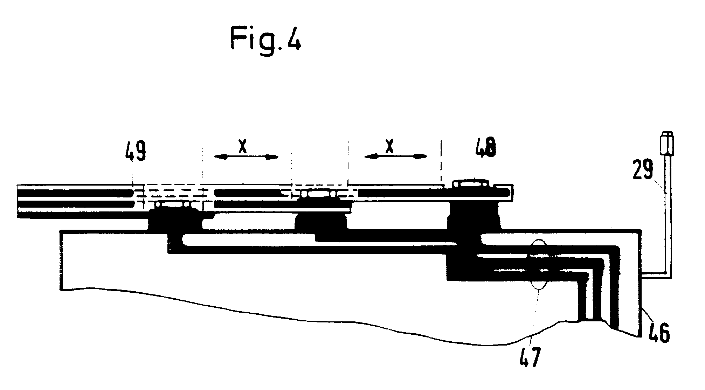

In Fig. 4 ist ein solcher Anschluß an ein Modul gemäß der ersten oder zweiten Ausführung skizziert. Fig. 4 zeigt ein Oberteil 46 eines Moduls mit einer dritten Anschlußbandleitung 47 und Schraubanschlüsse 48 sowie einen Schnitt durch eine mehrschichtige als Bandleitung ausgeführte Verbindungsschiene 49. Die Schraubanschlüsse 48 sind in einem an die Bandleitungsgeometrie angepaßten Abstand x angeordnet.

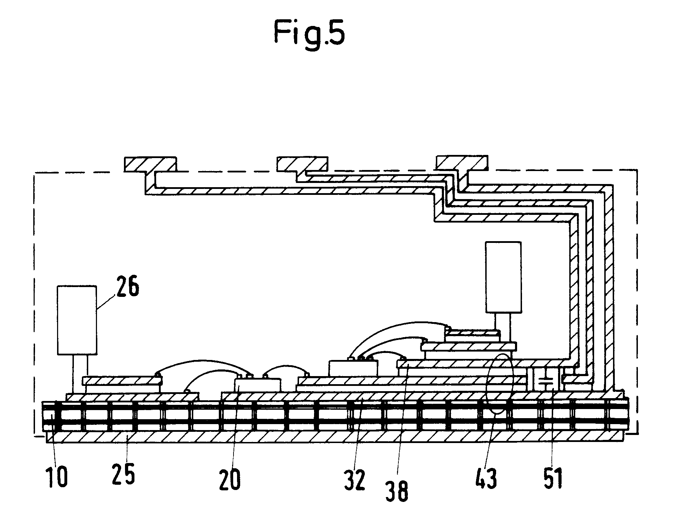

Fig. 5 zeigt nochmals in einer anderen Darstellung ein Modul gemäß der in Fig. 3 gezeigten zweiten Ausführungsform. Fig. 5 zeigt im Vergleich zu Fig. 3 zusätzlich die Anordnung mindestens eines Stützkondensators 51, welcher als Keramikkondensator in Chipform ausgeführt ist und unter Einhaltung der Bandleitungsgeometrie in die Verbindungsbandleitung 43 integriert ist.

Aus den Fig. 3 und 5 ist ersichtlich, daß der Wärmetransportweg von den Transistorchips 20 zu einem unterhalb der Bodenmetallisierung 25 anzuordnenden Kühlkörper unterschiedlich ist, je nachdem ob der Chip auf der Pluspolfläche 32 oder der Mittelanzapfungsfläche 36 angeordnet ist. Soweit sich daraus Probleme ergeben, können diese durch Wahl unterschiedlicher Dicke der Kupferfolien für die Pluspol- und Mittelanzapfungsflächen oder durch eine Lastaufteilung auf eine unterschiedliche Zahl von Transistorchips gelöst werden.

## Patentansprüche

1. Leistungshalbleitermodul mit
- mindestens einer Halbbrücke, wobei eine Halbbrücke erste und zweite in Reihe geschaltete Halbleiterschalter (1) enthält, die jeweils aus mehreren parallelgeschalteten ersten und zweiten Leistungstransistoren (2,20) bestehen,
- einem keramischen Substrat (10) als Modulboden, auf dem in einer Metallschichtebene liegende, isolierte Verbindungsleiterbahnen vorhanden sind, die aus einer Pluspolfläche (12), eine Mittelanzapfungsfläche (13), und mindestens zwei inselförmigen und elektrisch isoliert innerhalb der Mittelanzapfungsfläche (13) liegenden Minuspolflächen (15) bestehen; wobei:
- die ersten Transistoren (20) auf der Pluspolfläche (12) und die zweiten Transistoren (20) auf der Mittelanzapfungsfläche (13) aufgelötet sind;
- die ersten Transistoren (20) durch Drähte mit der Mittelanzapfungsfläche (13) und die zweiten Transistoren (20) durch Drähte mit den Minuspolflächen (15) elektrisch verbunden sind;
- drei Hauptanschlußleitungen (22,23,24) je Halbbrücke zur Stromführung zwischen drei Modul-Hauptanschlüssen und den Halbleiterschaltern vorhanden sind, wobei jede Hauptanschlußleitung (22,23,24) mit der jeweils zugehörigen Verbindungsleiterbahn (12,15,13) elektrisch leitend verbunden ist, und die drei Hauptanschlußleitungen (22,23,24) aus breiten Bändern mit geringem Abstand zueinander bestehen, um eine induktivitätsarme Anordnung zu erreichen; und
- die Pluspolanschlußleitung (22) im Bereich der Anschlußstelle mit der Pluspolfläche (12) mit Ausschnitten versehen ist, und wenigstens ein Teil der Drähte zur elektrischen Verbindung zwischen den ersten Transistoren und der Mittelanzapfungsfläche (13) durch die Ausschnitte der Pluspolanschlußleitung (22) geführt ist.

2. Leistungshalbleitermodul mit
- mindestens einer Halbbrücke, wobei eine Halbbrücke erste und zweite in Reihe geschaltete Halbleiterschalter (1) enthält, die aus mehreren parallelgeschalteten ersten bzw. zweiten Leistungstransistoren (20) bestehen;
- einem keramischen Substrat (10) als Modulboden, auf dem isolierte Verbindungsleiterbahnen vorhanden sind, die aus einer Pluspolfläche (32), einer Mittelanzapfungsfläche (36), und einer Minuspolfläche (38) in einer übereinandergeschichteten Folge der Pluspolfläche (32), einer zweiten Isolierschicht (35), der Mittelanzapfungsfläche (36), einer dritten Isolierschicht (37) und der Minuspolfäche (38) bestehen, wobei:
- die ersten Transistoren (20) auf der Pluspolfläche (32), und die zweiten Transistoren (20) auf der Mittelanzapfungsfläche (36) aufgelötet sind; die ersten Transistoren (20) durch Drähte mit der Mittelanzapfungsfläche (36) und die zweiten Transistoren (20) durch Drähte mit der Minuspolfläche (38) elektrisch verbunden sind;
- drei Hauptanschlußleitungen (44) je Halbbrücke für die Pluspol-, die Minuspol- und die Mittelanzapfungsfläche zur Stromführung zwischen drei Modul-Hauptanschlüssen und den Halbleiterschaltern vorhanden sind, wobei jede Hauptanschlußleitung mit der jeweils zugehörigen Verbindungsleiterbahn (32,36,38) elektrisch leitend verbunden ist, und die drei Hauptanschlußleitungen (44) aus breiten Bändern mit geringem Abstand zueinander bestehen, um eine induktivitätsarme Anordnung zu erreichen; und
- die Geometrie der Verbindungsleitungen sich in die Hauptanschlußleitungen fortsetzt.

3. Leistungshalbleitermodul nach einem der Ansprüche 1 oder 2, dadurch gekennzeichnet, daß die Modul-Hauptanschlüsse (45) an die Geometrie der Anschlußleitungen (9,44,47) angepaßt sind und mit Schraubanschlüssen (48) für den Anschluß externer Stromschienen (49) zur Verbindung von Leistungshalbleitermodulen ausgeführt sind.

4. Leistungshalbleitermodul nach einem der vorstehenden Ansprüche, dadurch gekennzeichnet, daß im Modul Ansteuerschaltungen (26) für die Leistungstransistoren (20) angeordnet sind und zugehörige Ansteuerleitungen (16 bis 19 bzw. 31, 34, 40, 42) zur Verbindung von Steueranschlüssen der Leistungstransistoren (20) untereinander und mit einem Ansteuerbaustein (26) in induktivitätsarmer Anordnung ausgeführt sind.

5. Leistungshalbleitermodul nach einem der vorstehenden Ansprüche, dadurch gekennzeichnet, daß das Modul in ein hauben- oder rahmenförmiges Kunststoffgehäuse eingesetzt ist.

6. Leistungshalbleitermodul nach einem der vorstehenden Ansprüche, dadurch gekennzeichnet, daß außer Transistoren (20) auch Freilaufdioden (21) im Modul enthalten sind.

7. Leistungshalbleitermodul nach einem der vorstehenden Ansprüche, dadurch gekennzeichnet, daß die Leistungstransistoren ausgewählt sind aus IGBT-Chips oder MOS-FETs.

8. Leistungshalbleitermodul nach einem der Ansprüche 2 bis 7, dadurch gekennzeichnet, daß in die Verbindungsleitung (43) wenigstens ein Stützkondensator (51) integriert, und elektrisch mit der Pluspolfläche und der Minuspolfläche verbunden ist, der als Keramikkondensator in Chipform ausgeführt ist.

## Claims

1. Power semiconductor module containing
- at least one half-bridge, a half-bridge containing first and second series-connected semiconductor switches (1) which each comprise a plurality of parallel-connected first and second power transistors (2, 20),
- a ceramic substrate (10) as module base on which there are present insulated connecting conductor tracks which are situated in a metal-layer level and which comprise a positive-pole area (12), a central-tapping area (13), and at least two insular negative-pole areas (15) which are situated in an electrically insulating manner inside the central tapping area (13); in which power semiconductor module
- the first transistors (20) are soldered on the positive-pole area (12) and the second transistors (20) on the central tapping area (13);
- the first transistors (20) are electrically connected by wires to the central tapping area (13) and the second transistors (20) are electrically connected by wires to the negative-pole areas (15);
- three main connecting leads (22, 23, 24) are present per half-bridge for carrying current between three main module connections and the semiconductor switches, each main connecting lead (22, 23, 24) being connected in an electrically conducting manner to the associated connecting conductor track (12, 15, 13) in each case and the three main connecting leads (22, 23, 24) comprising wide strips at a small distance from one another in order to achieve a low-inductance arrangement; and
- the positive-pole connecting lead (22) is provided with cutouts in the region of the point of connection to the positive-pole area (12), and at least some of the wires are connected to the electrical connection between the first transistors and the central tapping area (13) through the cutouts in the positive-pole connecting lead (22).

2. Power semiconductor module containing
- at least one half-bridge, a half-bridge containing first and second series-connected semiconductor switches (1) which comprise a plurality of parallel-connected first and second power transistors (20), respectively;
- a ceramic substrate (10) as module base on which there are present insulated connecting conductor tracks which comprise a positive-pole area (32), a central-tapping area (36), and a negative-pole area (38) in a laminated sequence of the positive-pole area (32), a second insulating layer (35), the central tapping area (36), a third insulating layer (37) and the negative-pole area (38), in which power semiconductor module:
- the first transistors (20) are soldered on the positive-pole area (32) and the second transistors (20) on the central tapping area (36);
- the first transistors (20) are electrically connected by wires to the central tapping area (36) and the second transistors (20) are electrically connected by wires to the negative-pole area (38);
- three main connecting leads (44) are present per half-bridge for the the positive-pole, the negative-pole and the central tapping area for carrying current between three main module connections and the semiconductor switches, each main connecting lead being connected in an electrically conducting manner to the associated connecting conductor track (32, 36, 38) in each case, and the three main connecting leads (44) comprising wide strips at a small distance from one another in order to achieve a low-inductance arrangement; and
- the geometry of the connecting leads is continued in the main connecting leads.

3. Power semiconductor module according to either of Claims 1 or 2, characterized in that the main module connections (45) are matched to the geometry of the connecting leads (9, 44, 47) and are designed with screw connections (48) for the connection of external current rails (49) for connecting power semiconductor modules.

4. Power semiconductor module according to one of the preceding claims, characterized in that drive circuits (26) for the power transistors (20) are disposed in the module and associated drive lines (16 to 19 or 31, 34, 40, 42) for connecting control connections of the power transistors (20) together and to a drive chip (26) are constructed in a low-inductance arrangement.

5. Power semiconductor module according to one of the preceding claims, characterized in that the module is inserted in a cap-shaped or frame-shaped plastic package.

6. Power semiconductor module according to one of the preceding claims, characterized in that, in addition to transistors (20), freewheeling diodes (21) are also contained in the module.

7. Power semiconductor module according to one of the preceding claims, characterized in that the power transistors are selected from IGBT chips or MOSFETs.

8. Power semiconductor module according to one of Claims 2 to 7, characterized in that at least one back-up capacitor (51) is integrated in the connecting lead (43) and electrically connected to the positive-pole area and the negative-pole area, which capacitor is designed as a ceramic capacitor in chip form.

## Revendications

1. Module à semi-conducteurs de puissance qui comporte
- au moins un demi-pont, un demi-pont comprenant des premiers et deuxièmes commutateurs (1) à semi-conducteurs connectés en série qui se composent chacun de plusieurs premiers et deuxièmes transistors de puissance (2, 20) connectés en parallèle,
- un substrat (10) céramique comme base du module, avec des pistes conductrices de connexion électriquement isolées qui sont disposées dans un plan formé d'une couche de métal et comprennent une surface de pôle positif (12), une surface de connexion intermédiaire (13) et au moins deux surfaces de pôle négatif (15) en forme d'îlots qui sont situées à l'intérieur de la surface de connexion intermédiaire (13) en étant isolées électriquement par rapport à celle-ci,
- les premiers transistors (20) étant soudés sur la surface de pôle positif (12) et les deuxièmes transistors (20) sur la surface de connexion intermédiaire (13),
- les premiers transistors (20) étant connectés par des fils à la surface de connexion intermédiaire (13) et les deuxièmes transistors (20) étant connectés par des fils à la surface de pôle négatif (15),
- trois conducteurs de connexion (22, 23, 24) principaux pour chaque demi-pont pour acheminer le courant entre trois bornes de connexion principales du module et les commutateurs à semi-conducteurs, chaque conducteur de connexion (22, 23, 24) principal étant relié de manière électro-conductrice à la piste conductrice de liaison (12, 15, 13) associée et les trois conducteurs de connexion (22, 23, 24) principaux étant constitués par des rubans larges disposés avec un faible espace entre eux afin d'obtenir un agencement à faible inductance, et
- le conducteur de connexion (22) de pôle positif étant pourvu de découpes dans la région de son raccordement avec la surface de pôle positif (12) et au moins une partie des fils assurant la liaison entre les premiers transistors et la surface de connexion intermédiaire (13) passant par les découpes du conducteur de connexion (22) du pôle positif.

2. Module à semi-conducteurs de puissance comportant
- au moins un demi-pont, un demi-pont comprenant des premiers et deuxièmes commutateurs (1) à semi-conducteurs connectés en série qui se composent chacun de plusieurs premiers et deuxièmes transistors de puissance (20) connectés en parallèle,
- un substrat (10) céramique comme base du module, avec des pistes conductrices de connexion électriquement isolées qui comprennent une surface de pôle positif (32), une surface de connexion intermédiaire (36) et une surface de pôle négatif (38) avec superposées dans l'ordre la couche de pôle positif (32), une deuxième couche isolante (35), la surface de connexion intermédiaire (36), une troisième couche isolante (37) et la surface de pôle négatif (38),
- les premiers transistors (20) étant soudés sur la surface de pôle positif (32) et les deuxièmes transistors (20) sur la surface de connexion intermédiaire (36),
- les premiers transistors (20) étant connectés électriquement par des fils à la surface de connexion intermédiaire (36) et les deuxièmes transistors (20) étant connectés par des fils à la surface de pôle négatif (38),
- trois conducteurs de connexion (44) principaux pour chaque demi-pont pour les surfaces de pôle positif, de connexion intermédiaire et de pôle négatif pour acheminer le courant entre trois bornes de connexion principales du module et les commutateurs à semi-conducteurs, chaque conducteur de connexion principal étant relié de manière électro-conductrice à la piste conductrice de liaison (32, 36, 38) associée et les trois conducteurs de connexion (44) principaux étant constitués par des rubans larges disposés avec un faible espace entre eux afin d'obtenir un agencement à faible inductance, et
- la forme des conducteurs de liaison se prolongeant dans les conducteurs de connexion principaux.

3. Module à semi-conducteurs de puissance selon l'une des revendications 1 ou 2, caractérisé par le fait que les connexions (45) principales du module sont adaptées à la forme des conducteurs de connexion (9, 44, 47) et sont pourvues de bornes à vis (48) pour la connexion de barres (49) de courant externes destinées à relier des modules à semi-conducteurs de puissance.

4. Module à semi-conducteurs de puissance selon l'une des revendications précédentes, caractérisé par le fait que des circuits de commande (26) pour les transistors de puissance (20) sont disposés dans le module et que des conducteurs de commande (16 à 19 et 31, 34, 40, 42) associés destinés à relier des connexions de commande des transistors de puissance (20) entre elles et à un composant de commande (26) sont agencés de manière à présenter une faible inductance.

5. Module à semi-conducteurs de puissance selon l'une des revendications précédentes, caractérisé par le fait que le module est monté dans un boîtier en matière plastique en forme de coiffe ou de châssis.

6. Module à semi-conducteurs de puissance selon l'une des revendications précédentes, caractérisé par le fait que le module contient, outre des transistors (20), des diodes roues libres (21).

7. Module à semi-conducteurs de puissance selon l'une des revendications précédentes, caractérisé par le fait que les transistors de puissance sont choisis parmi les puces à transistors IGBT ou parmi les transistors MOS FET.

8. Module à semi-conducteurs de puissance selon l'une des revendications 2 à 7, caractérisé par le fait qu'au moins un condensateur d'appoint (51) est intégré dans le conducteur de liaison (43) et est relié électriquement à la surface de pôle positif et à la surface de pôle négatif, lequel condensateur est un condensateur céramique en plaquette.
